# EUROPÄISCHE PATENTSCHRIFT

(11) **EP 3 514 447 B1**
(45) Veröffentlichungstag und Bekanntmachung des Hinweises auf die Patenterteilung: **27.12.2023**
(21) Anmeldenummer: 18152029.7
(22) Anmeldetag: 17.01.2018
(51) Int. Cl.: F21S 41/16, F21S 41/176, F21S 41/365, H01S 5/00, H01S 5/40, G02B 27/10, G02B 27/14

(54) **KRAFTFAHRZEUGSCHEINWERFER**
MOTOR VEHICLE HEADLAMP
PHARE DE VÉHICULE AUTOMOBILE

(43) Veröffentlichungstag der Anmeldung: 24.07.2019
(73) Patentinhaber: ZKW Group GmbH, 3250 Wieselburg (AT)
(72) Erfinder: Bissinger, Stephan, 2700 Wr. Neustadt (AT)
(74) Vertreter: Patentanwaltskanzlei Matschnig & Forsthuber OG

(56) Entgegenhaltungen:
- WO-A1-2015/174312
- WO-A1-2015/191659
- WO-A1-2018/003409
- CN-A- 101 004 483
- DE-A1-102013 200 521
- DE-A1-102015 202 961
- DE-A1-102015 218 535
- JP-A- 2015 069 952
- US-A1- 2012 224 384

## Beschreibung

Die Erfindung betrifft einen Kraftfahrzeugscheinwerfer gemäß dem Oberbegriff von Anspruch 1.

Es werden im Automobilbau verstärkt Lichtquellen für ein Lichtmodul, insbesondere für ein Lichtmodul eines Kraftfahrzeugscheinwerfers benötigt, welche über eine sehr hohe Lichtleistung verfügen, gleichzeitig kompakt in der Bauform, robust im Betrieb und überdies kostengünstig sind.

Aus der JP 2015 069952 A ist ein Kraftfahrzeugscheinwerfer bekannt, mit welchem ein Abblendlicht und ein Fernlicht mit einem einzigen Lampenkörper erzeugt werden kann.

Die WO 2015/174312 A1 zeigt eine Beleuchtungsvorrichtung für einen Fahrzeugscheinwerfer, mit vier Laserlichtquellen, wobei jeder Laserlichtquelle jeweils ein Reflektor zugeordnet ist.

Diese Anforderungen werden bei Lichtquellen nach dem Stand der Technik nicht immer erfüllt, was zu wirtschaftlichen und technischen Nachteilen führt.

Es ist eine Aufgabe der Erfindung, die Nachteile im Stand der Technik zu überwinden und einen Kraftfahrzeugscheinwerfer mit einer Anordnung für eine entsprechende Lichtquelle bereitzustellen.

Eine Aufgabe wird durch einen Kraftfahrzeugscheinwerfer gemäß Anspruch 1 gelöst, wobei jeder der einfallenden Lichtstrahlen entlang einer zugeordneten Einfallsrichtung normal zu einer Hauptebene der Spiegelvorrichtung in die Spiegelvorrichtung einläuft, und das Hauptlichtstrahlbündel normal zur Hauptebene der Spiegelvorrichtung ausgerichtet ist,
wobei die Spiegelvorrichtung für jeden einfallenden Lichtstrahl zumindest zwei Spiegel aufweist, welche im Strahlengang des jeweiligen Lichtstrahls angeordnet sind, nämlich einen Ablenkspiegel und einen Zentralspiegel
wobei jeder Ablenkspiegel eine Orientierung aufweist, die den ihm zugeordneten einfallenden Lichtstrahl aus der jeweiligen Einfallsrichtung zu dem ihm zugeordneten Zentralspiegel umlenkt,
wobei jeder Zentralspiegel eine Orientierung aufweist, die den so auf ihn umgelenkten Lichtstrahl normal zur Hauptebene der Spiegelvorrichtung umlenkt, wobei die Zentralspiegel zueinander in einer Anordnung positioniert sind, in der die Strahlengänge der Lichtstrahlen normal zur Hauptebene der Spiegelvorrichtung und nebeneinander liegen.

Dadurch wird erreicht, dass zumindest zwei einfallende, jeweils kollimierte Lichtstrahlen von Lichtquellen mittels der Spiegelvorrichtung umgelenkt und zu einem gemeinsamen Hauptlichtstrahlbündel gebündelt werden.

Mit der Orientierung der Spiegel zueinander ist gemeint, dass sowohl die Winkellage bezüglich der Hauptebene der Spiegelvorrichtung, die Position innerhalb der Spiegelvorrichtung oder die Beschaffenheit des Spiegels selbst, beispielsweise die Formgebung der Spiegelflächen der Spiegel entsprechend den Anforderungen in den jeweiligen Anwendungen gestaltet ist.

Beispielsweise kann die Oberfläche einer oder mehrerer Spiegelflächen seitens der Ablenk-, Koppel- und/oder Zentralspiegel gekrümmt ausgeführt sein, um eine spezielle Gesamtlichtverteilung im Erscheinungsbild der gebündelten Lichtstrahlen zu bewirken. Eine solche Lichtverteilung kann beispielsweise durch überlappende Lichtstrahlen im Hauptlichtstrahlbündel gebildet sein.

Es ist günstig, wenn die Zentralspiegel zueinander in einer Anordnung positioniert sind, in der die Strahlengänge der Lichtstrahlen in Richtung des Hauptlichtstrahlbündels gesehen aneinander angrenzend oder überlappend liegen. Dadurch kann das Hauptlichtstrahlbündels entsprechend einer gewünschten Gesamtlichtverteilung auf einfache Weise geformt werden.

Es ist günstig, wenn in der Hauptebene der Spiegelvorrichtung die geometrische Distanz zwischen den Ablenkspiegeln eines Paars von Strahlengängen der Lichtstrahlen größer ist, als die Distanz zwischen den Zentralspiegeln des Paars von Strahlengänge der Lichtstrahlen. Dadurch wird erreicht, dass die Lichtquellen günstig zueinander angeordnet werden können und eine kompakte Bauform eines Lichtmoduls bzw. eines Kraftfahrzeugscheinwerfers mit der Spiegelvorrichtung erzielbar ist.

Erfindungsgemäß verlaufen zumindest eine Einfallsrichtung und die Ausfallsrichtung zueinander gegenläufig. Auch dadurch wird erreicht, dass die Lichtquellen günstig zueinander angeordnet werden können und eine kompakte Bauform eines Lichtmoduls oder eines Kraftfahrzeugscheinwerfers erzielbar ist.

Es ist günstig, wenn zumindest zwei Ablenkspiegel und/oder zumindest zwei Zentralspiegel jeweils eine gemeinsame Spiegelfläche und/oder jeweils ein gemeinsames Bauteil bilden. Dadurch wird erreicht, dass die Spiegel günstig zueinander angeordnet werden können und eine kompakte Bauform der Spiegelvorrichtung, und somit eines Lichtmoduls oder eines Kraftfahrzeugscheinwerfers erzielbar ist. Ferner wird die Herstellung vereinfacht, wodurch die Spiegelvorrichtung kostengünstig hergestellt werden kann.

Außerdem ist es erfindungsgemäß vorgesehen, dass die Ablenkspiegel bzw. die Zentralspiegel um jeweilige Ablenkachsen bzw. Zentralachsen geneigt sind, welche Achsen parallel zu der Hauptebene orientiert sind. Vorzugsweise sind die Achsen in der Hauptebene gelegen. Dadurch wird erreicht, dass die Spiegel günstig zueinander angeordnet werden können und eine kompakte Bauform der Spiegelvorrichtung, und somit eines Lichtmoduls oder eines Kraftfahrzeugscheinwerfers erzielbar ist.

Es ist besonders günstig, wenn die Ablenkspiegel bzw. die Zentralspiegel jeweils um ± 45° bezüglich der Hauptebene der Spiegelvorrichtung geneigt sind.

Es ist vorteilhaft, wenn die Ablenkachsen von zumindest zwei Ablenkspiegeln koaxial bzw. die Zentralachsen von zumindest zwei Zentralspiegeln koaxial verlaufen. Dadurch wird erreicht, dass die Spiegel günstig zueinander angeordnet werden können und eine kompakte Bauform der Spiegelvorrichtung, und somit eines Lichtmoduls oder eines Kraftfahrzeugscheinwerfers erzielbar ist. Ferner wird die Herstellung vereinfacht, wodurch die Spiegelvorrichtung kostengünstig hergestellt werden kann.

Es ist außerdem erfindungsgemäß vorgesehen, dass zusätzlich zumindest ein Koppelspiegel im Strahlengang des jeweiligen Lichtstrahls zwischen dem jeweiligen Ablenkspiegel und dem jeweiligen Zentralspiegel angeordnet ist. Dadurch ist es möglich, dass mehrere Lichtstrahlen, ausgehend von entsprechenden Lichtquellen, durch die Spiegelvorrichtung umgelenkt und gebündelt werden. Gleichzeitig können die Spiegel in einer zueinander günstigen Lage bzw. Orientierung angeordnet werden und es ist eine kompakte Bauform der Spiegelvorrichtung, und somit eines Lichtmoduls oder eines Kraftfahrzeugscheinwerfers erzielbar. Ferner wird dadurch die Herstellung vereinfacht, wodurch die Spiegelvorrichtung kostengünstig hergestellt werden kann.

Es ist günstig, wenn zumindest zwei Koppelspiegel eine gemeinsame Spiegelfläche und/oder ein gemeinsames Bauteil bilden. Dadurch wird erreicht, dass die Spiegel in einer zueinander günstigen Lage bzw. Orientierung angeordnet werden können und eine kompakte Bauform der Spiegelvorrichtung, und somit eines Lichtmoduls oder eines Kraftfahrzeugscheinwerfers erzielbar ist. Ferner wird die Herstellung vereinfacht, wodurch die Spiegelvorrichtung kostengünstig hergestellt werden kann.

Außerdem ist erfindungsgemäß vorgesehen, dass der zumindest eine Koppelspiegel um eine Koppelachse geneigt ist, welche normal zur Hauptebene orientiert ist. Dadurch wird erreicht, dass die Spiegel in einer zueinander günstigen Lage bzw. Orientierung angeordnet werden können und eine kompakte Bauform der Spiegelvorrichtung, und somit eines Lichtmoduls oder eines Kraftfahrzeugscheinwerfers erzielbar ist. Ferner wird die Herstellung vereinfacht, wodurch die Spiegelvorrichtung kostengünstig hergestellt werden kann.

Es ist besonders günstig, wenn der zumindest eine Koppelspiegel um ± 45° bezüglich des Strahlengangs eines oder mehrerer Lichtstrahlen geneigt ist, bzw. normal zur Hauptebene der Spiegelvorrichtung orientiert ist.

Es ist vorteilhaft, wenn die Koppelachsen von zumindest zwei Koppelspiegeln koaxial verlaufen. Dadurch wird erreicht, dass die Spiegel in einer zueinander günstigen Lage bzw.

Orientierung angeordnet werden können und eine kompakte Bauform der Spiegelvorrichtung, und somit eines Lichtmoduls oder eines Kraftfahrzeugscheinwerfers erzielbar ist. Ferner wird die Herstellung vereinfacht, wodurch die Spiegelvorrichtung kostengünstig hergestellt werden kann.

In einer Weiterbildung der Erfindung ist auf dem zumindest einen Ablenkspiegel und/oder dem zumindest einen Zentralspiegel und/oder dem zumindest einem Koppelspiegel auf der jeweiligen Spiegelfläche eine Lichtkonversionsschicht, ein Konversions-Phosphor, aufgebracht. Dadurch ist es möglich, auf einfache Weise beispielsweise einen einfallenden Lichtstrahl in einem unsichtbaren Bereich des Lichtspektrums, beispielweise ein aus einer UV-Laserquelle emittiertes ultraviolettes Laserlicht in ein sichtbares Licht für eine Lichtfunktion eines Kraftfahrzeugscheinwerfers zu konvertieren. Die Konversion wird somit im selben Bauteil der Spiegelvorrichtung durchgeführt, in welchem das Umlenken und Bündeln der einzelnen einfallenden Lichtstrahlen erfolgt.

Vorzugsweise bilden der zumindest eine Ablenkspiegel und/oder der zumindest eine Zentralspiegel und/oder der optionale Koppelspiegel mittels einem Rahmen ein gemeinsames Bauteil.

Die Spiegel können zur einfacheren Fertigung gesondert hergestellt sein, und beispielsweise mittels Schrauben am Rahmen befestigt sein.

Es kann von Vorteil sein, wenn zusätzlich zum Rahmen eine Bodenplatte vorgesehen ist, welche den zumindest einen Zentralspiegel trägt. Es sind jedoch auch anderen Formen zur Befestigung des zumindest einen Zentralspiegels möglich.

Es ist erfindungsgemäß vorgesehen, dass der Kraftfahrzeugscheinwerfer zumindest zwei Lichtquellen umfasst, welche jeweils dazu eingerichtet sind, einen kollimierten Lichtstrahl zu emittieren, wobei die Strahlengänge der zumindest zwei Lichtstrahlen jeweils auf einen Ablenkspiegel geführt sind. Dadurch kann eine besonders kompakte Anordnung geschaffen werden, welche einen geringen Bauraum erfordert, oder auch die Anzahl der Lichtquellen weiter erhöht werden.

Es ist auch günstig, wenn der Kraftfahrzeugscheinwerfer zumindest drei Lichtquellen umfasst, welche jeweils dazu eingerichtet sind, einen kollimierten Lichtstrahl zu emittieren, wobei die Strahlengänge von zumindest zwei der zumindest drei Lichtstrahlen auf denselben Ablenkspiegel geführt sind. Dadurch kann eine noch kompaktere Anordnung geschaffen werden, welche einen geringen Bauraum erfordert, oder auch die Anzahl der Lichtquellen weiter erhöht werden.

Insbesondere sind für die Erfindung in einem Lichtmodul oder einem Scheinwerfer wichtige Teile beschrieben, wobei klar ist, dass ein Lichtmodul oder ein Scheinwerfer noch viele andere, nicht erwähnte Teile enthält, die einen sinnvollen Einsatz in einem Kraftfahrzeug, wie insbesondere einem PKW oder Motorrad, ermöglichen.

Die Erfindung und weitere Vorteile werden im Folgenden anhand von nicht einschränkenden Ausführungsbeispielen näher beschrieben, die in den beiliegenden Zeichnungen veranschaulicht sind. Die Zeichnungen zeigen in
- Fig. 1: eine schematische Ansicht einer ersten Ausführungsform eines Lichtmoduls eines erfindungsgemäßen Kraftfahrzeugscheinwerfers mit vier Lichtquellen und einer ersten Ausführungsform einer Spiegelvorrichtung eines erfindungsgemäßen Kraftfahrzeugscheinwerfers,
- Fig. 2: eine schematische Ansicht einer zweiten Ausführungsform eines Lichtmoduls eines erfindungsgemäßen Kraftfahrzeugscheinwerfers mit acht Lichtquellen und der ersten Ausführungsform einer Spiegelvorrichtung,
- Fig. 3: eine perspektivische Ansicht des Lichtmoduls nach der Fig. 2,
- Fig. 4: eine vereinfachte perspektivische Ansicht des Lichtmoduls nach der Fig. 2,
- Fig. 5: eine perspektivische Ansicht der ersten Ausführungsform der Spiegelvorrichtung,
- Fig. 6: eine schematische Ansicht einer dritten nicht erfindungsgemäßen Ausführungsform eines Lichtmoduls mit zwei Lichtquellen und einer zweiten Ausführungsform einer Spiegelvorrichtung,
- Fig. 7: eine schematische Ansicht einer vierten Ausführungsform eines Lichtmoduls eines erfindungsgemäßen Kraftfahrzeugscheinwerfers mit sechzehn Lichtquellen und der ersten Ausführungsform der Spiegelvorrichtung,
- Fig. 8: einen Ausschnitt des Lichtmoduls nach der Fig. 7 in einer vereinfachten perspektivischen Ansicht,
- Fig. 9: eine schematische Ansicht eines erfindungsgemäßen Kraftfahrzeugscheinwerfers mit einem Lichtmodul.

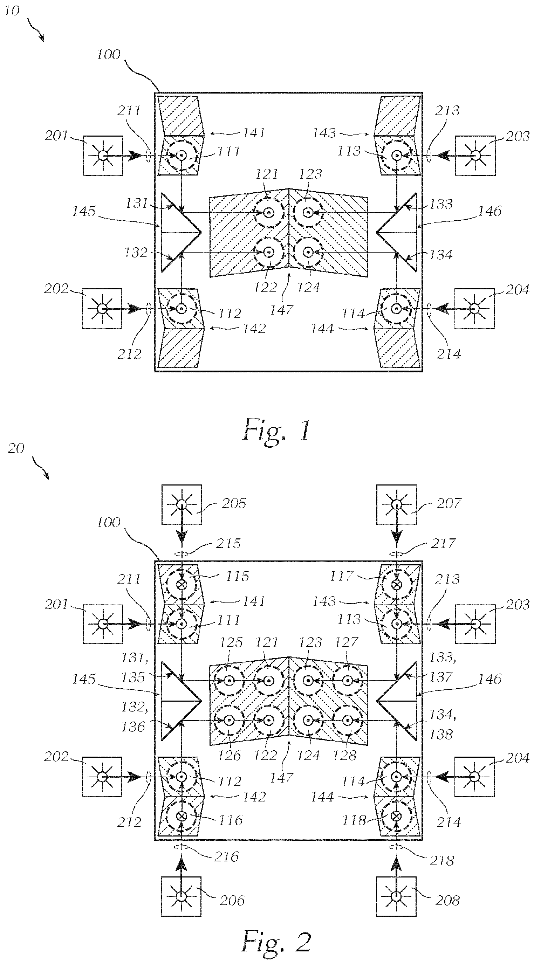

Unter Bezugnahme auf Fig. 1 bis Fig. 9 werden nun Ausführungsbeispiele der Erfindung näher erläutert. Insbesondere sind für die Erfindung in einem Lichtmodul oder einem Scheinwerfer wichtige Teile dargestellt, wobei klar ist, dass ein Lichtmodul oder ein Scheinwerfer noch viele andere, nicht gezeigte Teile enthält, die einen sinnvollen Einsatz in einem Kraftfahrzeug, wie insbesondere einem PKW oder Motorrad, ermöglichen. Der Übersichtlichkeit halber sind daher beispielsweise Kühlvorrichtungen für Bauteile, Ansteuerungselektronik, weitere optische Elemente, mechanische Verstelleinrichtungen beziehungsweise Halterungen nicht gezeigt.

In diesem Zusammenhang wird unter einem Spiegel, beispielsweise einem Ablenkspiegel oder einem Zentralspiegel eine im Strahlengang des jeweiligen Lichtstrahls wirksame und reflektierende Oberfläche bezeichnet.

Mehrere Spiegel können dabei auf einer gemeinsamen, physischen Spiegelfläche ausgebildet sein.

Mehrere Spiegelflächen, welche in unterschiedliche Richtungen orientiert sind, können ein gemeinsames Bauteil bilden.

In den schematischen Figuren sind Spiegel durch kreisrunde Flächen, welche von einem strichliertem Rand begrenzt sind, gekennzeichnet. Der strichlierte Rand soll darstellen, dass dort die optisch wirksame Fläche des Spiegels endet. Spiegelflächen sind beispielsweise als rautenartige, schraffierte Flächen gekennzeichnet.

In den schematischen Figuren sind Strahlengänge von Lichtstrahlen jeweils mit einem Kreis und einem zentrischen Punkt eingezeichnet, um zu kennzeichnen, dass der jeweilige Strahlengang aus der Ebene der Zeichnung heraus gerichtet ist, und der Strahlengang somit normal zur Zeichnungsebene verlaufen.

In den schematischen Figuren sind Strahlengänge von Lichtstrahlen jeweils mit einem Kreis und einem zentrischen Kreuz eingezeichnet, um zu kennzeichnen, dass der jeweilige Strahlengang in die Ebene der Zeichnung hinein gerichtet ist, und der Strahlengang somit normal zur Zeichnungsebene verlaufen.

Rautenförmig dargestellte Spiegelbauteile sollen veranschaulichen, dass einfallende Strahlengänge durch die jeweiligen Spiegel von Richtungen, welche normal zu der Zeichnungsebene verlaufen, in die Zeichnungsebene umgelenkt werden, oder umgekehrt.

Dreieckförmig dargestellte Spiegel sollen veranschaulichen, dass einfallende Strahlengänge nur innerhalb der Zeichnungsebene umgelenkt werden.

**Fig. 1** zeigt schematisch ein Ausführungsbeispiel für ein Lichtmodul 10 eines Kraftfahrzeugscheinwerfers, welches vier Lichtquellen 201-204 umfasst, welche jeweils dazu eingerichtet sind, einen kollimierten Lichtstrahl 211-214 zu emittieren.

Das Lichtmodul 10 umfasst ferner eine Spiegelvorrichtung 100, wobei die Strahlengänge der vier Lichtstrahlen 211-214 jeweils auf einen Ablenkspiegel 111-114 der Spiegelvorrichtung 100 geführt sind.

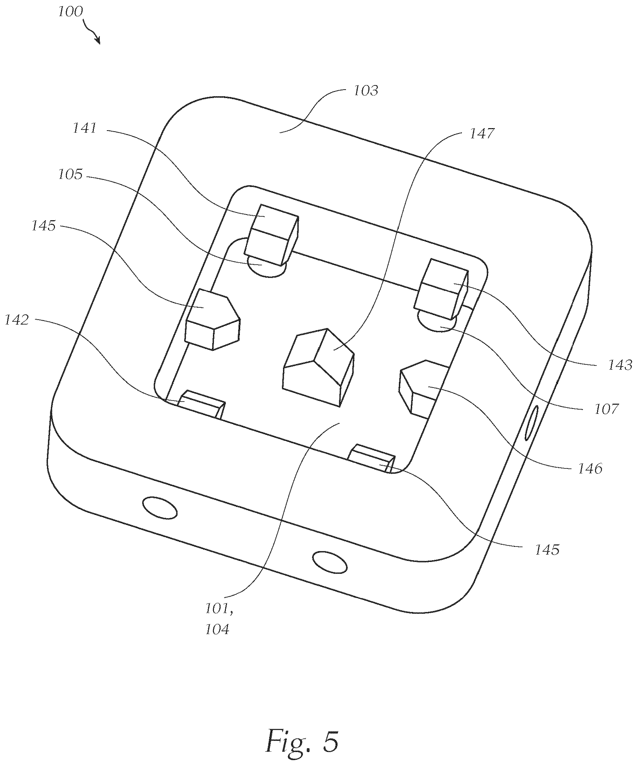

Die Spiegelvorrichtung 100, welche in Fig. 5 beispielhaft in Form eines Bauteils gezeigt ist, dient zum Umlenken und Bündeln von vier einfallenden, jeweils kollimierten Lichtstrahlen 211-214 zu einem gemeinsamen Hauptlichtstrahlbündel.

Jeder der einfallenden Lichtstrahlen 211-214 läuft entlang einer zugeordneten Einfallsrichtung normal zu einer Hauptebene 101 der Spiegelvorrichtung 100 in die Spiegelvorrichtung 100 ein. Das Hauptlichtstrahlbündel ist normal zur Hauptebene 101 der Spiegelvorrichtung 100 ausgerichtet.

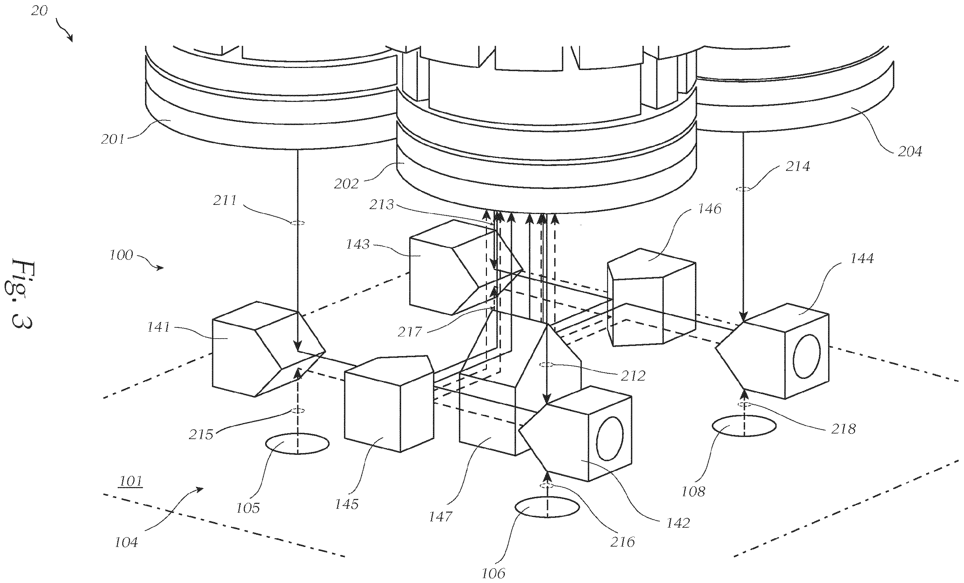

Die Hauptebene 101 der Spiegelvorrichtung 100 ist beispielsweise in Fig. 3 oder Fig. 5 erkennbar.

Die Spiegelvorrichtung 100 weist für jeden einfallenden Lichtstrahl 211-214 zumindest zwei Spiegel auf, welche im Strahlengang des jeweiligen Lichtstrahls 211-214 angeordnet sind, nämlich jeweils einen Ablenkspiegel 111-114 und jeweils einen Zentralspiegel 121-124. Jeder Ablenkspiegel 111-114 weist eine Orientierung, Position und Formgebung auf, die den ihm zugeordneten einfallenden Lichtstrahl 211-214 aus der jeweiligen Einfallsrichtung zu dem ihm zugeordneten Zentralspiegel 121-124 umlenkt.

Jeder Zentralspiegel 121-124 weist eine Orientierung, Position und Formgebung auf, die den auf ihn umgelenkten Lichtstrahl 211-214 in Richtung des Hauptlichtstrahlbündels umlenkt. Die Zentralspiegel 121-124 sind zueinander in einer Anordnung positioniert, in der die Strahlengänge der Lichtstrahlen 211-214 in Richtung des Hauptlichtstrahlbündels gesehen nebeneinander liegen. Bei besonderen Ausführungen kann es auch vorgesehen sein, dass die Strahlengänge der Lichtstrahlen aneinander angrenzen oder einander überlappen.

In der Hauptebene 101 der Spiegelvorrichtung 100 ist die geometrische Distanz zwischen den Ablenkspiegeln 111-114 eines Paars von Strahlengängen der Lichtstrahlen 211-214 größer, als die Distanz zwischen den Zentralspiegeln 121-124 des Paars von Strahlengängen der Lichtstrahlen 211-214.

Die vier Einfallsrichtungen und die Ausfallsrichtung verlaufen zueinander nicht erfindungsgemäß gleichläufig, wie durch die Richtungen der Strahlengänge der Lichtstrahlen 111-114 an den jeweiligen Orten an den Ablenkspiegeln 111-114 bzw. den Zentralspiegeln 121-124 durch die Kennzeichnung eines Kreises mit einem zentrischen Punkt erkennbar ist. Das bedeutet, dass sowohl die vier Einfallsrichtungen von unter in die Zeichnungsebene und die Ausfallsrichtung nach oben aus der Zeichnungsebene verlaufen.

Alternativ und erfindungsgemäß verlaufen die Einfallsrichtungen und die Ausfallsrichtung der Lichtstrahlen bei Verwendung von benachbarten Spiegeln, welche in diesem Beispiel nicht eingesetzt sind und jeweils in Form eines einteiligen Bauteils 141-144 mit den jeweiligen Ablenkspiegeln 111-114 gebildet sind, gegenläufig. In der Fig. 1 ist eine nicht erfindungsgemäße gleichläufige Variante gezeigt.

Zwei Zentralspiegel 121,122 bzw. 123, 124 bilden jeweils eine gemeinsame Spiegelfläche und die vier Zentralspiegel 121-124, welche auf zwei Spiegelflächen ausgebildet sind, bilden insgesamt ein gemeinsames Bauteil 147, wie durch das Ausführungsbeispiel der Spiegelvorrichtung 100 gemäß Fig. 5 gezeigt ist.

Die Ablenkspiegel 111-114 bzw. die Zentralspiegel 121-124 sind um jeweilige

Ablenkachsen 151-154 bzw. Zentralachsen 161-164 geneigt, welche Achsen in der Hauptebene 101 gelegen oder parallel zu dieser orientiert sind.

Die Ablenkachsen 151-154 der vier Ablenkspiegel 111-114 verlaufen koaxial, und die Zentralachsen 161-164 der vier Zentralspiegel 121-124 verlaufen koaxial.

Außerdem ist jeweils ein Koppelspiegel 131-134 im Strahlengang des jeweiligen Lichtstrahls 211-214 zwischen dem jeweiligen Ablenkspiegel 111-114 und dem jeweiligen Zentralspiegel 121-124 angeordnet.

Zwei Koppelspiegel 131,132 bzw. 133,134 bilden jeweils ein gemeinsames Bauteil 145 bzw. 146.

Die Koppelspiegel 131-134 sind jeweils um eine Koppelachse 171-174 geneigt, welche normal zur Hauptebene 101 orientiert ist.

Die Koppelachsen 171-174 von jeweils zwei Koppelspiegeln 131-134 verlaufen koaxial.

Optional kann auf zumindest einem Ablenkspiegel 111-114 und/oder einem Zentralspiegel 121-124 und/oder einem Koppelspiegel 131-134 eine Lichtkonversionsschicht aufgebracht sein. Dies kann dazu dienen, falls das einfallende Licht in einem für einen Menschen unsichtbaren Spektralbereich liegt, der in einen sichtbaren Spektralbereich für einen Einsatz in einen Kraftfahrzeugscheinwerfer konvertiert werden soll. Diese Lichtkonversionsschicht kann auf der Spiegelfläche eines Ablenkspiegel 111-114 und/oder eines Zentralspiegels 121-124 und/oder eines Koppelspiegels 131-134 angeordnet werden, ist in den Figuren jedoch nicht dargestellt.

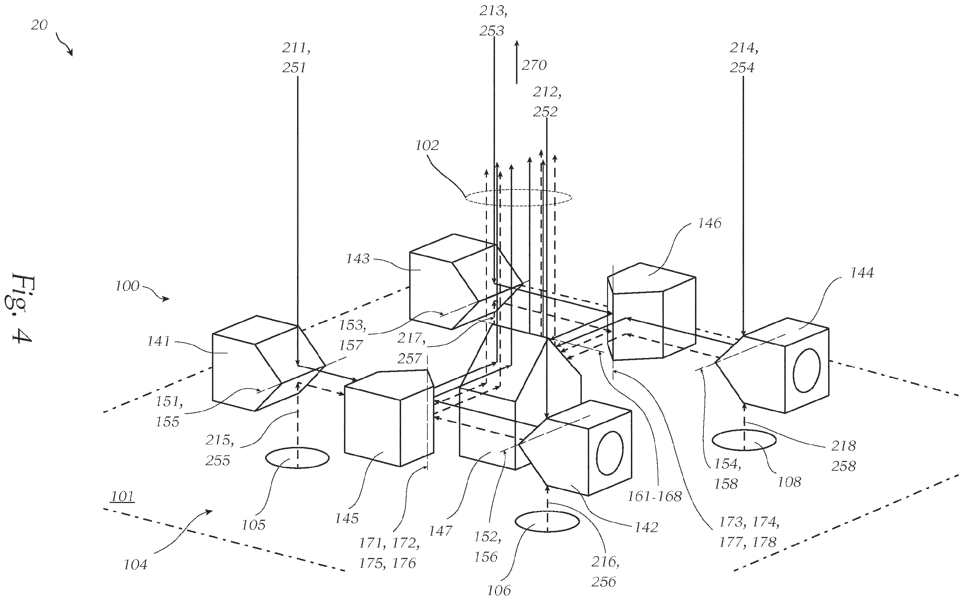

**Fig. 2****,** **Fig. 3** und **Fig. 4** zeigen schematisch ein Ausführungsbeispiel für ein Lichtmodul 20 eines Kraftfahrzeugscheinwerfers, welches acht Lichtquellen 211-218 umfasst, welche jeweils dazu eingerichtet sind, einen kollimierten Lichtstrahl 211-218 zu emittieren. In **Fig. 3** und **Fig. 4** ist das Lichtmodul 20 mit der Spiegelvorrichtung 100 der Fig. 2 perspektivisch dargestellt, wobei die Darstellung der Fig. 4 die Anordnung 20 vereinfacht zeigt. Die Anmerkungen zur Fig. 1 hinsichtlich der Spiegelvorrichtung 100 gelten gleichermaßen.

Das Lichtmodul 20 umfasst wiederum eine Spiegelvorrichtung 100 aus der Fig. 1, wobei die Strahlengänge der nun acht Lichtstrahlen 211-218 mit jeweiligen Einfallsrichtungen 251-258 jeweils auf einen Ablenkspiegel 111-118 geführt sind.

Die Spiegelvorrichtung 100 dient zum Umlenken und Bündeln von acht einfallenden, jeweils kollimierten Lichtstrahlen 211-218 zu einem gemeinsamen Hauptlichtstrahlbündel 102.

Jeder der einfallenden Lichtstrahlen 211-218 läuft entlang einer zugeordneten Einfallsrichtung 251-258 normal zu einer Hauptebene 101 der Spiegelvorrichtung 100 in die Spiegelvorrichtung 100 ein. Das Hauptlichtstrahlbündel 102 in Richtung einer Ausfallsrichtung 270 ist normal zur Hauptebene 101 der Spiegelvorrichtung 100 ausgerichtet.

Die Spiegelvorrichtung 100 weist für jeden einfallenden Lichtstrahl 211-218 zumindest zwei Spiegel auf, welche im Strahlengang des jeweiligen Lichtstrahls 211-218 angeordnet sind, nämlich jeweils einen Ablenkspiegel 111-118 und jeweils einen Zentralspiegel 121-128. Jeder Ablenkspiegel 111-118 weist eine Orientierung, Position und Formgebung auf, die den ihm zugeordneten einfallenden Lichtstrahl 211-218 aus der jeweiligen Einfallsrichtung zu dem ihm zugeordneten Zentralspiegel 121-128 umlenkt.

Jeder Zentralspiegel 121-128 weist eine Orientierung, Position und Formgebung auf, die den auf ihn umgelenkten Lichtstrahl 211-218 in Richtung des Hauptlichtstrahlbündels umlenkt. Die Zentralspiegel 121-128 sind zueinander in einer Anordnung positioniert, in der die Strahlengänge der Lichtstrahlen 211-218 in Richtung des Hauptlichtstrahlbündels gesehen nebeneinander, vorzugsweise aneinander angrenzend, liegen. Bei besonderen Ausführungen kann es auch vorgesehen sein, dass die Strahlengänge der Lichtstrahlen einander überlappen.

In der Hauptebene 101 der Spiegelvorrichtung 100 ist die geometrische Distanz zwischen den Ablenkspiegeln 111-118 eines Paars von Strahlengängen der Lichtstrahlen 211-218 größer, als die Distanz zwischen den Zentralspiegeln 121-128 des Paars von Strahlengängen der Lichtstrahlen 211-218.

Die vier Einfallsrichtungen 251-254 und die Ausfallsrichtung 270 verlaufen zueinander gegenläufig, wie durch die Richtungen der Strahlengänge der Lichtstrahlen 111-118 an den jeweiligen Orten an den Ablenkspiegeln 111-118 bzw. den Zentralspiegeln 121-128 durch die Kennzeichnung eines Kreises mit einem zentrischen Punkt erkennbar ist.

Das bedeutet, dass die vier Einfallsrichtungen 251- 254 der Strahlengänge der Lichtstrahlen 111-114 führen von oben in die Zeichnungsebene, welche der Hauptebene 101 entspricht.

Die weiteren vier Einfallsrichtungen 255-258 der Strahlengänge der Lichtstrahlen 115-118 führen von unten in die Zeichnungsebene. Somit verlaufen die vier Einfallsrichtungen 255-258 und die Ausfallsrichtung 270 zueinander gleichläufig. Die Ausfallsrichtung 270 der acht Strahlengänge der Lichtstrahlen 111-118 verläuft nach oben aus der Zeichnungsebene.

Jeweils zwei Ablenkspiegel 111 und 115, 112 und 116,113 und 117, sowie 114 und 118 bilden jeweils ein gemeinsames Bauteil 141-144.

Vier Zentralspiegel 121, 122, 125 und 126 bzw. 123, 124, 127 und 128 bilden jeweils eine gemeinsame Spiegelfläche und die acht Zentralspiegel 121-128, welche auf zwei Spiegelflächen ausgebildet sind, bilden insgesamt ein gemeinsames Bauteil 147, wie durch das Ausführungsbeispiel der Spiegelvorrichtung 100 gemäß Fig. 5 gezeigt ist.

Die Ablenkspiegel 111-118 bzw. die Zentralspiegel 121-128 sind um jeweilige Ablenkachsen 151-158 bzw. Zentralachsen 161-168 geneigt, welche Achsen in der Hauptebene 101 gelegen oder parallel zu dieser orientiert sind.

Die Ablenkachsen 151-158 der acht Ablenkspiegel 111-118 verlaufen koaxial, und die Zentralachsen 161-168 der acht Zentralspiegel 121-128 verlaufen koaxial.

Die Ablenkspiegel 111-118 bzw. die Zentralspiegel 121-128 sind jeweils um ± 45° bezüglich der Hauptebene 101 der Spiegelvorrichtung 1 geneigt.

Außerdem ist jeweils ein Koppelspiegel 131-138 im Strahlengang des jeweiligen Lichtstrahls 211-218 zwischen dem jeweiligen Ablenkspiegel 111-118 und dem jeweiligen Zentralspiegel 121-128 angeordnet.

Jeweils zwei Koppelspiegel 131 und 135,132 und 136,133 und 137, sowie 134 und 138 bilden jeweils eine gemeinsame Spiegelfläche und die Koppelspiegel 131,132,135 und 136, sowie 133,134,137 und 138 bilden jeweils ein gemeinsames Bauteil 145 und 146.

Die Koppelspiegel 131-138 sind jeweils um eine Koppelachse 171-178 geneigt, welche normal zur Hauptebene 101 orientiert ist.

Die Koppelachsen 171-178 von jeweils vier Koppelspiegeln 131,132,135 und 136, bzw. 133, 134,137 und 138 verlaufen koaxial.

Die Koppelspiegel 131-138 sind bezüglich des Strahlengangs der Lichtstrahlen 211-218 um ± 45° geneigt, bzw. normal zur Hauptebene 101 der Spiegelvorrichtung 1 orientiert.

Optional kann auf zumindest einem Ablenkspiegel 111-118 und/oder einem Zentralspiegel 121-128 und/oder einem Koppelspiegel 131-138 eine Lichtkonversionsschicht aufgebracht sein. Dies kann dazu dienen, falls das einfallende Licht in einem für einen Menschen unsichtbaren Spektralbereich liegt, der in einen sichtbaren Spektralbereich für einen Einsatz in einen Kraftfahrzeugscheinwerfer konvertiert werden soll. Diese Lichtkonversionsschicht kann auf der Spiegelfläche eines Ablenkspiegel 111-118 und/oder eines Zentralspiegels 121-128 und/oder eines Koppelspiegels 131-138 angeordnet werden, ist in den Figuren jedoch nicht dargestellt.

Die **Fig. 5** zeigt ein Ausführungsbeispiel einer Spiegelvorrichtung 100 eines Kraftfahrzeugscheinwerfers.

Die Spiegel-Bauteile 141-147 sind mit einem gemeinsamen Rahmen 103 verbunden bzw. bilden ein gemeinsames Bauteil der Spiegelvorrichtung 100, wobei das Zentralspiegel-Bauteil 147 mittels einer Bodenplatte 104 mit dem Rahmen 103 verbunden ist. Die Bodenplatte 104 weist Öffnungen 105-108 auf, um das Einfallen von kollimierte Lichtstrahlen 231-238 auf die zugeordneten Spiegelflächen der Ablenkspiegel 111-118 zu erlauben.

Das Ausführungsbeispiel für eine Spiegelvorrichtung 100 gemäß der Fig. 2 bis Fig. 5 zeigt eine Orientierung der Ablenkspiegel 111-118 von +45° oder -45° jeweils bezüglich der Hauptebene 101, das heißt die Ablenkachsen 151-158 liegen parallel zur Hauptebene 101. Jeweils zwei Ablenkspiegel 111-118 mit jeweils einer Spiegelfläche bilden ein gemeinsames Ablenkspiegel-Bauteil 141-144.

Die Zentralspiegel 121-128 weisen eine Orientierung von +45° oder -45° jeweils bezüglich der Hauptebene 101 auf, das heißt die Zentralachsen 161-168 liegen parallel zur Hauptebene 101. Jeweils vier Zentralspiegel 121-128 bilden jeweils eine Spiegelfläche. Jeweils zwei Spiegelflächen der Zentralspiegel 121-128 bilden ein gemeinsames Zentralspiegel-Bauteil 147.

Die Koppelspiegel 131-138 weisen eine Orientierung von +45° oder -45° jeweils bezüglich einer Normalen zur Hauptebene 101 auf, das heißt die Koppelachsen 171-178 liegen normal zur Hauptebene 101. Jeweils zwei Koppelspiegel 131-138 bilden jeweils eine Spiegelfläche. Jeweils zwei Spiegelflächen der Koppelspiegel 131-138 bilden ein gemeinsames Koppelspiegel-Bauteil 145-146,181-188.

Grundsätzlich sind andere Orientierungen der Spiegel möglich, wobei jeweils eine Abstimmung untereinander erforderlich ist, um die gewünschte Umlenkung und Bündelung zu erreichen.

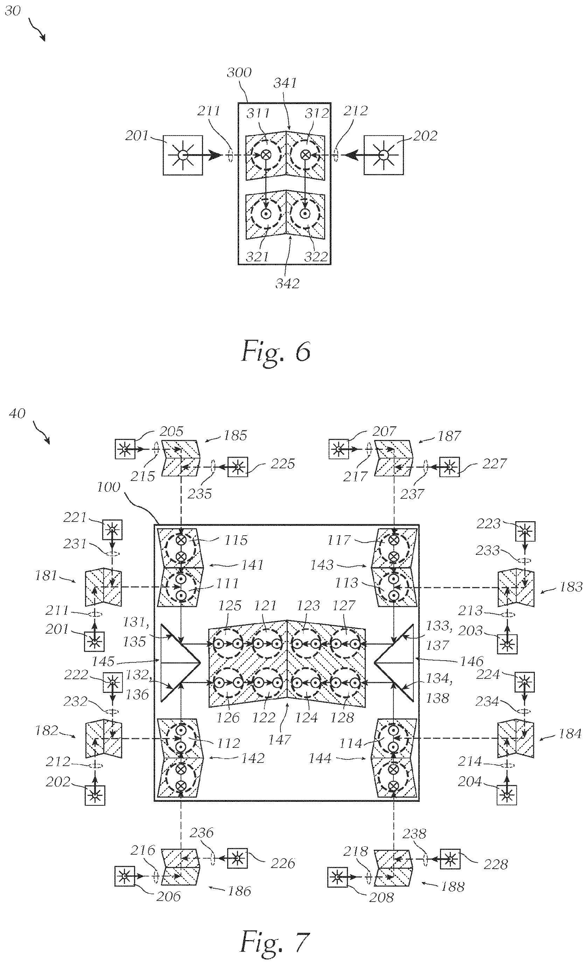

**Fig. 6** zeigt schematisch ein nicht erfindungsgemäßes Ausführungsbeispiel für ein Lichtmodul 30 eines Kraftfahrzeugscheinwerfers, welches zwei Lichtquellen 201, 202 umfasst, welche jeweils dazu eingerichtet sind, einen kollimierten Lichtstrahl 211, 212 zu emittieren.

Das Lichtmodul 30 umfasst ferner eine Spiegelvorrichtung 300, wobei die Strahlengänge der zwei Lichtstrahlen 211, 212 jeweils auf einen Ablenkspiegel 311, 312 der Spiegelvorrichtung 300 geführt sind.

Die Ablenkspiegel 311, 312 bilden ein gemeinsames Bauteil 341 und die Zentralspiegel 321, 322 bilden ein gemeinsames Bauteil 342. Die Anordnung verfügt über keine Koppelspiegel. Außerdem gelten die Ausführungen der vorhergehenden Beispiele.

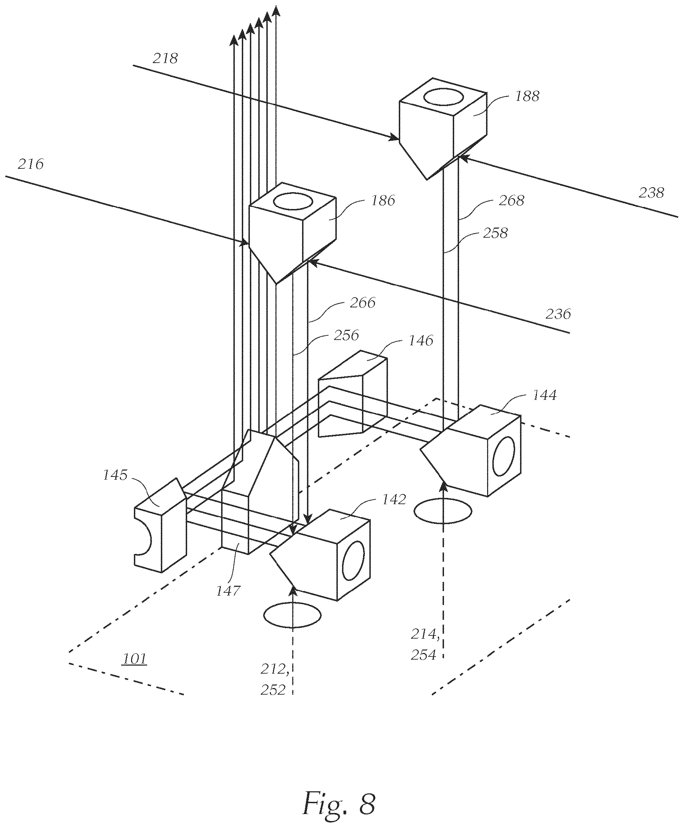

**Fig. 7** und **Fig. 8** zeigen schematisch ein Ausführungsbeispiel für ein Lichtmodul 40 eines Kraftfahrzeugscheinwerfers, welches 16 Lichtquellen 201-218, 211-228 umfasst, welche jeweils dazu eingerichtet sind, einen kollimierten Lichtstrahl 211-218, 221-228 zu emittieren. Das Lichtmodul 40 umfasst ferner eine Spiegelvorrichtung 100, wobei die Strahlengänge der 16 Lichtstrahlen 211-218, 221-228 jeweils auf einen Ablenkspiegel 111-118 der Spiegelvorrichtung 100 geführt sind.

Im Unterschied zum Ausführungsbeispiel der Fig. 2 bis Fig. 5 sind jeweils zwei Strahlengänge der Lichtstrahlen 211-218, 231-238 jeweils auf denselben Ablenkspiegel 111-118 geführt. Die wird durch die Anordnung von Spiegelbauteilen 181-188 erreicht, welche als Koppelspiegel eingesetzt werden und zwei Lichtstrahlen aus zwei verschiedenen, bevorzugt entgegengesetzten Richtungen umlenken und bündeln.

Beispielsweise werden Lichtstrahlen 211 und 231 mittels der Spiegel auf dem Spiegelbauteil 181 umgelenkt und gebündelt. Dadurch wird erreicht, dass jeweils zwei parallele Strahlengänge der Lichtstrahlen 211-218, 231-238 auf jeweils einen Ablenkspiegel 111-118 der Spiegelvorrichtung 100 geführt sind.

In Fig. 8 sind die Strahlengänge der Lichtstrahlen 212, 214, 216, 218, 236 und 238 erkennbar.

Die Strahlengänge der Lichtstrahlen 216 und 236 werden durch ein Spiegelbauteil 186 gebündelt und in Richtung des Ablenkspiegelbauteils 142 umgelenkt.

Die Strahlengänge der Lichtstrahlen 218 und 238 werden durch ein Spiegelbauteil 188 gebündelt und in Richtung des Ablenkspiegelbauteils 144 umgelenkt.

Das Ablenkspiegelbauteil 142 bündelt die Strahlengänge der Lichtstrahlen 212, 216 und 236 und lenkt sie in Richtung des Koppelspiegelbauteils 145 um.

Das Ablenkspiegelbauteil 144 bündelt die Strahlengänge der Lichtstrahlen 214, 218 und 238 und lenkt sie in Richtung des Koppelspiegelbauteils 146 um.

Das Koppelspiegelbauteil 145 bündelt die Strahlengänge der Lichtstrahlen 212, 216 und 236 und lenkt sie in Richtung des Zentralspiegelbauteils 147 um.

Das Koppelspiegelbauteil 146 bündelt die Strahlengänge der Lichtstrahlen 214, 218 und 238 und lenkt sie in Richtung des Zentralspiegelbauteils 147 um.

Die anderen Strahlengänge im Lichtmodul 40 und Teile der Anordnung sind nicht dargestellt.

Außerdem gelten die Ausführungen der vorhergehenden Beispiele.

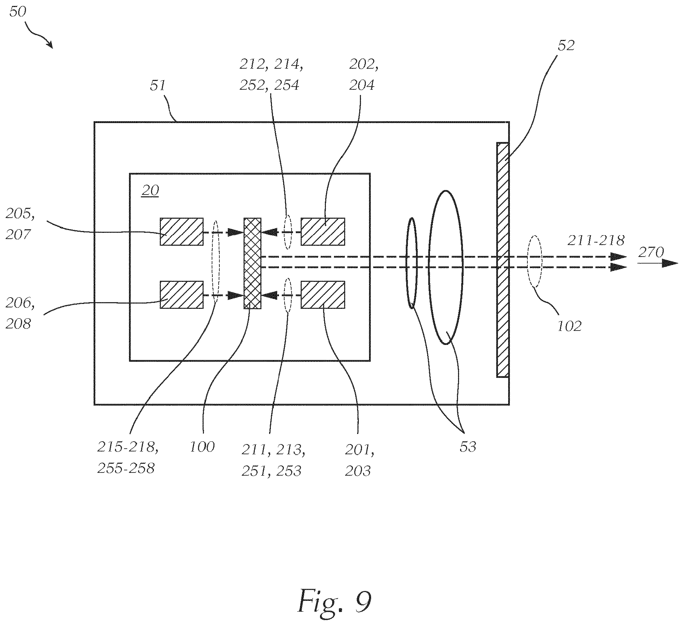

**Fig. 9** zeigt schematisch einen Kraftfahrzeugscheinwerfer 50 mit einem Scheinwerfergehäuse 51 und einer transparenten Scheinwerfer-Scheibe 52.

Der Kraftfahrzeugscheinwerfer 50 umfasst ferner das Lichtmodul 20 gemäß der Fig. 3 bis Fig. 5, welches auf einem gemeinsamen Halter befestige Lichtquellen 201-208 und die Spiegelvorrichtung 100 beinhaltet.

Die Strahlengänge der von den Lichtquellen 201-208 in Richtung der Ausfallsrichtung 270 emittierten Lichtstrahlen 211-218 bilden das Hauptlichtstrahlbündel 102 und können mittels einer Projektionsoptik 53 weiter geformt werden. Je nach Anwendung können weitere optische Elemente, wie beispielsweise Blenden oder Reflektoren, im jeweiligen Strahlengang angeordnet werden.

### Bezugszeichenliste

- 10, 20, 30,40: Lichtmodul
- 50: Kraftfahrzeugscheinwerfer
- 51: Scheinwerfergehäuse
- 52: Scheinwerfer-Scheibe
- 53: Projektionsoptik
- 100, 300: Spiegelvorrichtung
- 101: Hauptebene
- 102: Hauptlichtstrahlbündel
- 103: Rahmen
- 104: Bodenplatte
- 105-108: Öffnung
- 111-118: Ablenkspiegel
- 121-128: Zentralspiegel
- 131-138: Koppelspiegel
- 141-147,181-188: Spiegelbauteil
- 151-158: Ablenkachse
- 161-168: Zentralachse
- 171-178: Koppelachse
- 201-208, 221-228: Lichtquelle
- 211-218, 231-238: Lichtstrahl
- 251-258, 266, 268: Einfallsrichtung
- 270: Ausfallsrichtung

## Patentansprüche

1. Kraftfahrzeugscheinwerfer (50) umfassend zumindest zwei Lichtquellen (211-218, 231-238), welche jeweils dazu eingerichtet sind, einen kollimierten Lichtstrahl (211-218, 231-238) zu emittieren, eine Spiegelvorrichtung (100, 300) zum Umlenken und Bündeln der zumindest zwei von den Lichtquellen einfallenden, jeweils kollimierten Lichtstrahlen (211-218, 231-238) zu einem gemeinsamen Hauptlichtstrahlbündel (102), wobei jeder der einfallenden Lichtstrahlen (211-218, 231-238) entlang einer zugeordneten Einfallsrichtung (251-258, 266, 268) normal zu einer Hauptebene (101) der Spiegelvorrichtung (100, 300) in die Spiegelvorrichtung (100, 300) einläuft, und das Hauptlichtstrahlbündel (102) normal zur Hauptebene (101) der Spiegelvorrichtung (100, 300) ausgerichtet ist,
wobei die Spiegelvorrichtung (100, 300) für jeden einfallenden Lichtstrahl (211-218, 231-238) zumindest zwei Spiegel aufweist, welche im Strahlengang des jeweiligen Lichtstrahls (211-218, 231-238) angeordnet sind, nämlich einen Ablenkspiegel (111-118) und einen Zentralspiegel (121-128),
wobei jeder Ablenkspiegel (111-118) eine Orientierung aufweist, die den ihm zugeordneten einfallenden Lichtstrahl (211-218, 231-238) aus der jeweiligen Einfallsrichtung (251-258, 266, 268) zu dem ihm zugeordneten Zentralspiegel (121-128) umlenkt,
wobei jeder Zentralspiegel (121-128) eine Orientierung aufweist, die den so auf ihn umgelenkten Lichtstrahl (211-218, 231-238) normal zur Hauptebene (101) der Spiegelvorrichtung (100, 300) umlenkt, wobei die Zentralspiegel (121-128) zueinander in einer Anordnung positioniert sind, in der die Strahlengänge der Lichtstrahlen (211-218, 231-238) normal zur Hauptebene (101) der Spiegelvorrichtung (100, 300) und nebeneinander liegen, wobei
die Ablenkspiegel (111-118) bzw. die Zentralspiegel (121-128) um jeweilige Ablenkachsen (151-158) bzw. Zentralachsen (161-168) geneigt sind welche Achsen parallel zu der Hauptebene (101) orientiert sind, wobei
außerdem zumindest ein Koppelspiegel (131-138) im Strahlengang des jeweiligen Lichtstrahls (211-218, 231-238) zwischen dem jeweiligen Ablenkspiegel (111-118) und dem jeweiligen Zentralspiegel (121-128) angeordnet ist, **dadurch gekennzeichnet, dass**
der zumindest eine Koppelspiegel (131-138) um eine Koppelachse (171-178) geneigt ist, welche normal zur Hauptebene (101) orientiert ist,
und **dass**
zumindest eine Einfallsrichtung (251-258, 266, 268) der einfallenden Lichtstrahlen (211-218, 231-238) und die Ausfallsrichtung (270) des Hauptlichtstrahlbündels (102) zueinander gegenläufig verlaufen.

2. Kraftfahrzeugscheinwerfer (50) nach Anspruch 1, **dadurch gekennzeichnet, dass** die Zentralspiegel (121-128) zueinander in einer Anordnung positioniert sind, in der die Strahlengänge der Lichtstrahlen (211-218, 231-238) normal zu einer Hauptebene (101) der Spiegelvorrichtung (100, 300) gesehen aneinander angrenzend oder überlappend liegen.

3. Kraftfahrzeugscheinwerfer (50) nach Anspruch 1 oder 2, **dadurch gekennzeichnet, dass** in der Hauptebene (101) der Spiegelvorrichtung (100, 300) die geometrische Distanz zwischen den Ablenkspiegeln (111-118) eines Paars von Strahlengängen der Lichtstrahlen (211-218, 231-238) größer ist, als die Distanz zwischen den Zentralspiegeln (121-128) des Paars von Strahlengänge der Lichtstrahlen (211-218, 231-238).

4. Kraftfahrzeugscheinwerfer (50) nach einem der vorhergehenden Ansprüche, **dadurch gekennzeichnet, dass** zumindest zwei Ablenkspiegel (111-118) und/oder zumindest zwei Zentralspiegel (121-128) jeweils eine gemeinsame Spiegelfläche und/oder jeweils ein gemeinsames Bauteil (141-147, 181-188) bilden.

5. Kraftfahrzeugscheinwerfer (50) nach einem der vorhergehenden Ansprüche, **dadurch gekennzeichnet, dass** die Ablenkachsen (151-158) von zumindest zwei Ablenkspiegeln (111-118) koaxial bzw. die Zentralachsen (161-168) von zumindest zwei Zentralspiegeln (121-128) koaxial verlaufen.

6. Kraftfahrzeugscheinwerfer (50) nach einem der vorhergehenden Ansprüche, **dadurch gekennzeichnet, dass** zumindest zwei Koppelspiegel (131-138) eine gemeinsame Spiegelfläche und/oder ein gemeinsames Bauteil (141-147, 181-188) bilden.

7. Kraftfahrzeugscheinwerfer (50) nach einem der vorhergehenden Ansprüche, **dadurch gekennzeichnet, dass** die Koppelachsen (171-178) von zumindest zwei Koppelspiegeln (131-138) koaxial verlaufen.

8. Kraftfahrzeugscheinwerfer (50) nach einem der vorhergehenden Ansprüche, **dadurch gekennzeichnet, dass** auf zumindest einem Koppelspiegel (131-138) eine Lichtkonversionsschicht aufgebracht ist.

9. Kraftfahrzeugscheinwerfer (50) nach einem der vorhergehenden Ansprüche, **dadurch gekennzeichnet, dass** auf dem zumindest einen Ablenkspiegel (111-118) und/oder dem zumindest einen Zentralspiegel (121-128) eine Lichtkonversionsschicht aufgebracht ist.

10. Kraftfahrzeugscheinwerfer (50) nach einem der vorhergehenden Ansprüche, umfassend zumindest drei Lichtquellen (201-208, 221-228), welche jeweils dazu eingerichtet sind, einen kollimierten Lichtstrahl (211-218, 231-238) zu emittieren, **dadurch gekennzeichnet, dass** die Strahlengänge von zumindest zwei der zumindest drei Lichtstrahlen (211-218, 231-238) auf denselben Ablenkspiegel (111-118) geführt sind.

## Claims

1. Motor vehicle headlamp (50) comprising at least two light sources (211-218, 231-238) each adapted to emit a collimated light beam (211-218, 231-238), a mirror device (100, 300) for deflecting and bundling the at least two respective collimated light beams (211-218, 231-238) incident from the light sources into a common main light beam bundle (102), wherein each of the incident light beams (211-218, 231-238) enters the mirror device (100, 300) along an associated direction of incidence (251-258, 266, 268) normal to a main plane (101) of the mirror device (100, 300), and the main light beam bundle (102) is aligned normal to the main plane (101) of the mirror device (100, 300),
wherein the mirror device (100, 300) has at least two mirrors for each incident light beam (211-218, 231-238), which are arranged in the beam path of the respective light beam (211-218, 231-238), namely a deflecting mirror (111-118) and a central mirror (121-128),
each deflecting mirror (111-118) having an orientation which deflects the incident light beam (211-218, 231-238) assigned to it from the respective direction of incidence (251-258, 266, 268) to the central mirror (121-128) assigned to it,
wherein each central mirror (121-128) has an orientation which deflects the light beam (211-218, 231-238) thus deflected onto it normal to the main plane (101) of the mirror device (100, 300), wherein the central mirrors (121-128) are positioned relative to one another in an arrangement in which the beam paths of the light beams (211-218, 231-238) are normal to the main plane (101) of the mirror device (100, 300) and adjacent to one another, wherein
the deflection mirrors (111-118) or the central mirrors (121-128) are inclined about respective deflection axes (151-158) or central axes (161-168), which axes are oriented parallel to the main plane (101), wherein
in addition, at least one coupling mirror (131-138) is arranged in the beam path of the respective light beam (211-218, 231-238) between the respective deflecting mirror (111-118) and the respective central mirror (121-128), **characterized in that**
the at least one coupling mirror (131-138) is inclined about a coupling axis (171-178) which is oriented normal to the main plane (101),
and that
at least one direction of incidence (251-258, 266, 268) of the incident light beams (211-218, 231-238) and the direction of emission (270) of the main light beam (102) run in opposite directions to one another.

2. Motor vehicle headlamp (50) according to claim 1, **characterized in that** the central mirrors (121-128) are positioned relative to one another in an arrangement in which the beam paths of the light beams (211-218, 231-238) are adjacent to one another or overlapping when viewed normal to a main plane (101) of the mirror device (100, 300).

3. Motor vehicle headlamp (50) according to claim 1 or 2, **characterized in that**, in the main plane (101) of the mirror device (100, 300), the geometric distance between the deflecting mirrors (111-118) of a pair of beam paths of the light beams (211-218, 231-238) is greater than the distance between the central mirrors (121-128) of the pair of beam paths of the light beams (211-218, 231-238).

4. Motor vehicle headlamp (50) according to one of the preceding claims, **characterized in that** at least two deflecting mirrors (111-118) and/or at least two central mirrors (121-128) each form a common mirror surface and/or a common component (141-147, 181-188) in each case.

5. Motor vehicle headlamp (50) according to one of the preceding claims, **characterized in that** the deflection axes (151-158) of at least two deflection mirrors (111-118) run coaxially or the central axes (161-168) of at least two central mirrors (121-128) run coaxially.

6. Motor vehicle headlamp (50) according to one of the preceding claims, **characterized in that** at least two coupling mirrors (131-138) form a common mirror surface and/or a common component (141-147, 181-188).

7. Motor vehicle headlamp (50) according to one of the preceding claims, **characterized in that** the coupling axes (171-178) of at least two coupling mirrors (131-138) run coaxially.

8. Motor vehicle headlamp (50) according to one of the preceding claims, **characterized in that** a light conversion layer is applied to at least one coupling mirror (131-138).

9. Motor vehicle headlamp (50) according to one of the preceding claims, **characterized in that** a light conversion layer is applied to the at least one deflecting mirror (111-118) and/or the at least one central mirror (121-128).

10. Motor vehicle headlamp (50) according to one of the preceding claims, comprising at least three light sources (201-208, 221-228), which are each set up to emit a collimated light beam (211-218, 231-238), **characterized in that** the beam paths of at least two of the at least three light beams (211-218, 231-238) are guided onto the same deflecting mirror (111-118).

## Revendications

1. Projecteur de véhicule automobile (50) comprenant au moins deux sources lumineuses (211-218, 231-238) qui sont respectivement adaptées pour émettre un faisceau lumineux collimaté (211-218, 231-238), un dispositif de miroir (100, 300) pour dévier et concentrer les au moins deux faisceaux lumineux (211-218, 231-238) incidents provenant des sources lumineuses, respectivement collimatés, en un faisceau lumineux principal commun (102), chacun des faisceaux lumineux incidents (211-218, 231-238) entrant dans le dispositif à miroir (100, 300) le long d'une direction d'incidence associée (251-258, 266, 268) normale à un plan principal (101) du dispositif à miroir (100, 300), et le faisceau lumineux principal (102) étant orienté normalement au plan principal (101) du dispositif à miroir (100, 300),
le dispositif à miroirs (100, 300) présentant, pour chaque faisceau lumineux incident (211-218, 231-238), au moins deux miroirs qui sont disposés sur le trajet du faisceau lumineux respectif (211-218, 231-238), à savoir un miroir de déviation (111-118) et un miroir central (121-128),
chaque miroir de déviation (111-118) présentant une orientation qui dévie le faisceau lumineux incident (211-218, 231-238) qui lui est associé de la direction d'incidence respective (251-258, 266, 268) vers le miroir central (121-128) qui lui est associé,
chaque miroir central (121-128) ayant une orientation qui dévie le faisceau lumineux (211-218, 231-238) ainsi dévié sur lui, perpendiculairement au plan principal (101) du dispositif à miroir (100, 300), les miroirs centraux (121-128) étant positionnés les uns par rapport aux autres dans un agencement dans lequel les trajets des faisceaux lumineux (211-218, 231-238) sont perpendiculaires au plan principal (101) du dispositif à miroir (100, 300) et adjacents les uns aux autres, dans lequel
les miroirs de déviation (111-118) et les miroirs centraux (121-128) sont respectivement inclinés autour d'axes de déviation (151-158) et d'axes centraux (161-168) respectifs, lesquels axes sont orientés parallèlement au plan principal (101), dans lequel
en outre, au moins un miroir de couplage (131-138) est disposé dans le trajet du faisceau lumineux respectif (211-218, 231-238) entre le miroir de déviation respectif (111-118) et le miroir central respectif (121-128), **caractérisé en ce que**
le au moins un miroir de couplage (131-138) est incliné autour d'un axe de couplage (171-178) qui est orienté normalement au plan principal (101),
et **en ce que**
au moins une direction d'incidence (251-258, 266, 268) des rayons lumineux incidents (211-218, 231-238) et la direction de sortie (270) du faisceau lumineux principal (102) sont opposées l'une à l'autre.

2. Projecteur de véhicule automobile (50) selon la revendication 1, **caractérisé en ce que** les miroirs centraux (121-128) sont positionnés l'un par rapport à l'autre dans un agencement dans lequel les trajets des faisceaux lumineux (211-218, 231-238) sont adjacents ou se chevauchent, vus perpendiculairement à un plan principal (101) du dispositif de miroir (100, 300).

3. Projecteur de véhicule automobile (50) selon la revendication 1 ou 2, **caractérisé en ce que**, dans le plan principal (101) du dispositif de miroir (100, 300), la distance géométrique entre les miroirs de déviation (111-118) d'une paire de trajets des rayons lumineux (211-218, 231-238) est supérieure à la distance entre les miroirs centraux (121-128) de la paire de trajets des rayons lumineux (211-218, 231-238).

4. Projecteur de véhicule automobile (50) selon l'une des revendications précédentes, **caractérisé en ce qu'**au moins deux miroirs de déviation (111-118) et/ou au moins deux miroirs centraux (121-128) forment chacun une surface de miroir commune et/ou chacun un composant commun (141-147, 181-188).

5. Projecteur de véhicule automobile (50) selon l'une des revendications précédentes, **caractérisé en ce que** les axes de déviation (151-158) d'au moins deux miroirs de déviation (111-118) sont coaxiaux ou les axes centraux (161-168) d'au moins deux miroirs centraux (121-128) sont coaxiaux.

6. Projecteur de véhicule automobile (50) selon l'une des revendications précédentes, **caractérisé en ce qu'**au moins deux miroirs de couplage (131-138) forment une surface réfléchissante commune et/ou un composant commun (141-147, 181-188).

7. Projecteur de véhicule automobile (50) selon l'une quelconque des revendications précédentes, **caractérisé en ce que** les axes de couplage (171-178) d'au moins deux miroirs de couplage (131-138) sont coaxiaux.

8. Projecteur de véhicule automobile (50) selon l'une des revendications précédentes, **caractérisé en ce qu'**une couche de conversion de lumière est déposée sur au moins un miroir de couplage (131-138).

9. Projecteur de véhicule automobile (50) selon l'une des revendications précédentes, **caractérisé en ce qu'**une couche de conversion de lumière est déposée sur ledit au moins un miroir de déviation (111-118) et/ou sur ledit au moins un miroir central (121-128).

10. Projecteur de véhicule automobile (50) selon l'une quelconque des revendications précédentes, comprenant au moins trois sources lumineuses (201-208, 221-228) agencées chacune pour émettre un faisceau lumineux collimaté (211-218, 231-238), **caractérisé en ce que** les trajets d'au moins deux desdits au moins trois faisceaux lumineux (211-218, 231-238) sont guidés sur un même miroir de déviation (111-118).
